Europäisches Patentamt

European Patent Office

Office européen des brevets

(11) Veröffentlichungsnummer: **0 320 592 B1**

(12) **EUROPÄISCHE PATENTSCHRIFT**

(45) Veröffentlichungstag der Patentschrift: **17.03.93**

(21) Anmeldenummer: **88116861.1**

(22) Anmeldetag: **11.10.88**

(51) Int. Cl.⁵: **H05K 9/00**

(54) **Elektromagnetisch abgeschirmte Kabine.**

(30) Priorität: **16.12.87 DE 8716599 U**

(43) Veröffentlichungstag der Anmeldung:
**21.06.89 Patentblatt 89/25**

(45) Bekanntmachung des Hinweises auf die
Patenterteilung:
**17.03.93 Patentblatt 93/11**

(84) Benannte Vertragsstaaten:
**AT BE CH DE ES FR GB GR IT LI NL SE**

(56) Entgegenhaltungen:
**DE-A- 2 601 277**
**DE-A- 3 305 928**
**FR-A- 2 580 891**
**US-A- 2 858 520**

(73) Patentinhaber: **ZEPPELIN-Metallwerke GmbH**
**Postfach 25 40**
**W-7990 Friedrichshafen 1(DE)**

(72) Erfinder: **Schaepers, Arno**
**Stockerholz 8/A**
**W-7990 Friedrichshafen 1(DE)**
Erfinder: **Grabherr, Bernd**
**Knollengraben 39**
**W-7980 Ravensburg(DE)**

(74) Vertreter: **Patentanwälte Grünecker, Kinkel-**
**dey, Stockmair & Partner**
**Maximilianstrasse 58**
**W-8000 München 22 (DE)**

**Beschreibung**

Die Erfindung bezieht sich auf eine elektromagnetisch abgeschirmte Kabine der im Oberbegriff von Anspruch 1 erläuterten Art.

Um hochsensible Elektronik-Einrichtungen, Rechnersysteme usw. gegen hochfrequente elektro-magnetische Wellen oder Felder abzuschirmen, werden Schirmkabinen verwendet. Die Kabinen bieten sowohl eine Abschirmung gegen das Ein- und Abstrahlen von elektro-magnetischen Funk- oder Radarwellen als auch gegen elektro-magnetische Störungen, beispielsweise durch einen Blitzeinschlag. Darüber hinaus schützen die Kabinen, insbesondere bei Verwendung im militärischen Bereich, die Elektronik-Einrichtungen auch gegen eine Zerstörung durch einen nuklear-eletromagnetischen Impuls, d.h. gegen das starke elektromagnetische Feld, das bei einer nuklearen Expolsion entsteht.

Ein Schwachpunkt der Abschirmung ist der Stoßbereich zwischen einem feststehenden Bauteil, d.h. einer festen Wand, und einem beweglichen Wandteil, wie beispielsweise einer Tür, einer Klappe, einer Luke oder eines beweglichen Fensters. Auch diese Stoßbereiche müssen bei geschlossener Wand die erforderlichen Schirmdämpfungswerte erreichen, wobei die Übergangswiderstände nur in Milliohm-Bereich liegen dürfen. Es ist deshalb erforderlich, einen guten elektrischen Kontakt über den Stoßbereich herzustellen.

Aus der DE-A-26 01 277 ist eine elektomagnetisch abgeschirmte Kabine der oben erläuterten Art bekannt. Die Kabine weist ein Dichtungssystem zwischen einem Türrahmen aus dickem Metallblech, beispielsweise aus plattiertem Stahl, und einer Tür aus einer Stahlkonstruktion auf. Das Dichtungssystem besteht aus einem Messerkontakt aus plattiertem Stahl, der zwischen Kontaktfedern aus Berylliumkupfer eingeschoben wird. Das Dichtungssystem der bekannten Kabine erbringt jedoch nach Aussagen dieser Druckschrift nur mit der beschriebenen Werkstoffkombination ausreichende Dämpfungswerte, wobei ausdrücklich erwähnt wird, daß diese Dämpfungswerte auf keinen Fall durch die Verwendung von Aluminium erreicht werden können.

In der Veröffentlichung der Firma Siemens "EMV Raumabschirmung, Kabinenteile, Filter", Ausgabe 83/84, ist ein für den Stoßbereich verwendbares Dichtungssystem beschrieben, das dort Messerkontakt genannt wird. Ein Teil dieses Dichtungssystems besteht aus zwei in einer Nut angeordneten Kontaktfedern, wobei die Nut einen im wesentlichen rechteckigen Querschnitt aufweist. Das zweite Teil ist ein umbördelter, streifenförmiger Kontaktsteg mit langgestreckt rechteckigem Querschnitt, der als Abwinkelung des Türrahmens ausgebildet ist. Wird die Tür geschlossen, so drückt sich der umbördelte Bereich des Kontaktsteges derart zwischen die Kontaktfedern, daß diese leicht verformt werden und sich dadurch in einem leitenden Kontakt sowohl an die Wandungen der Nut als auch an die Oberfläche des Kontaktsteges anlegen. Die Kabine besteht aus einem Rahmen aus Profilen und einer Stahlblechfüllung. Der Kontaktsteg besteht somit ebenfalls aus Stahl. Um sicherzustellen, daß sich der elektrische Kontakt über den Stoßbereich mit der Zeit nicht verschlechtert, muß das Dichtungssystem in regelmäßigen Intervallen gereinigt und gegen Rost geschützt werden. Dieser Rostschutz wird durch einen dünnen Fettfilm erreicht, der jedoch seinerseits auch den Übergangswiderstand erhöhen wird.

Das Problem der Reinigung und Pflege des Dichtungssystems wird dann besonders gravierend, wenn mobile Kabinen zur Gewichtsersparnis aus Aluminium gebaut werden sollen. Das Aluminium bildet bei Kontakt mit dem Luftsauerstoff auf seiner Oberfläche sofort eine Oxidhaut, die den Übergangswiderstand erhöht. Um überhaupt annehmbare Abschirmungswerte zu erreichen, müßte ein derartiges Dichtungssystem aus Aluminium täglich gereinigt werden, was weder zumutbar ist, noch im praktischen Betrieb durchgeführt werden wird.

Der Erfindung liegt somit die Aufgabe zugrunde, eine elektromagnetisch abgeschirmte Kabine mit einem Dichtungssystem bereitzustellen, das auch bei Verwendung von Aluminium als Konstruktionswerkstoff für die Kabine wartungsarm ist und hohe Schirmdämpfungswerte erreicht.

Die Aufgabe wird durch die kennzeichnenden Merkmale des Anspruchs 1 gelöst.

Durch die erfindungsgemäße Zinnbeschichtung wird eine sehr gute Kontaktierung zwischen den miteinander in Eingriff stehenden Kontaktflächen erreicht. Die erzielbaren Schirmdämpfungswerte liegen auch bei Verwendung von Aluminium als Konstruktionswerkstoff für die Wand und/oder die Tür merklich über den einschlägigen Standards. Die Schirmdämpfung verschlechtert sich auch im Dauerbetrieb nicht, was wohl darauf zurückzuführen ist, daß Zinn ein relativ weiches Metall ist, so daß durch Relativbewegung zwischen den Kontaktflächen Oxidhäute entfernt, die Kontaktflächen somit blankgehalten werden, und ein formschlüssiger Kontaktsitz regelrecht ausgearbeitet wird. Gleichzeitig bildet Zinn auch unter starker Umweltbeanspruchung nur eine extrem dünne Oxidschicht, die eine gute Kontaktierung nicht behindert.

Bisher wurde Zinn für rein elektrische Verbindungen, beispielsweise für Permanentverbindungen oder als Überzug bei Klemmverbindungen, die nur selten zu lösen sind, eingesetzt. Die US-A-2 858 520 beschreibt eine Klemme aus einem Aluminiumwerkstoff, die über haftvermittelnde Schichten aus Zink und Kupfer mit einer Cadmiumschicht als Korrosionsschutz versehen ist. Um die bei Wechselstrombelastung auftretende zyklische Erwärmung durch die Cadmiumschicht zu reduzieren, wurde außen auf die Cadmiumschicht ein dünner, poröser Film aus bevorzugt Nickel, aber auch Zinn, aufgebracht. Dabei soll die Cadmiumschicht durch die Poren des porösen Films in elektrischen Kontakt mit dem geklemmten Draht stehen. Dies bedingt jedoch, daß die Klemme mit einem derart hohen Anpreßdruck angezogen wird, daß die Kontaktstellen ineinanderfließen. Die Kontaktklemme ist somit nur für den einmaligen Gebrauch bestimmt. Hinweise darauf, daß eine Zinnbeschichtung auch für Dichtungssysteme von elektromagnetisch abgeschirmten Kabinen einsetzbar sind, sind dieser Druckschrift nicht zu entnehmen.

Weiterhin zeigt die DE-A-33 05 928 einen Steckverbinder für gedruckte Schaltungen, der in Form eines Messerkontaktes ausgebildet ist. Eine der beiden Kontaktflächen des Messerkontaktes und die anliegende Kontaktfläche der Kontaktfeder sind jeweils mit einem edlen Metall, beispielsweise Gold oder Palladium beschichtet, während die gegenüberliegende Kontaktfläche des Messerkontaktes und die anliegende Kontaktfläche der Kontaktfeder mit Zinn beschichtet sind. Als Basismaterial wird für die Feder ein Federwerkstoff und für den Messerkontakt Messing angegeben. Beschichtungen aus Edelmetall sind jedoch bei den großen Dichtflächen für das Dichtungssystem einer elektromagnetisch abgeschirmten Kabine viel zu kostenaufwendig. Darüber hinaus sind die Zinnbeschichtung und die Beschichtung aus edlem Material elektrisch leitend miteinander verbunden, was insbesondere bei Verwendung im Außenbereich (hohe Luftfeuchtigkeit und Regen) zu Kontaktkorrosion führen kann, bei der das unedle Metall aufgezehrt wird. Darüber hinaus wird in der Druckschrift eine beidseitige Zinnbeschichtung als nachteilig angesehen.

Die Maßnahme nach Anspruch 2 verbessert die Haftung der Zinnbeschichtung auf Aluminiumoberflächen.

Die Kombination Zink-Zinn gemäß Anspruch 3 führt zu einer vergleichsweise guten Abriebfestigkeit.

Es hat sich herausgestellt, daß der Kontakt weiter verbessert wird, wenn gemäß Anspruch 4 auch die Kontaktfedern verzinnt sind, auch wenn diese aus einem anderen Material als Aluminium bestehen.

Zum Aufbringen der Zinnbeschichtung wird gemäß Anspruch 5 bevorzugt das Flammspritzverfahren angewandt.

Von besonderem Vorteil ist die Ausgestaltung nach den Ansprüchen 6 und 7. Durch den keilförmigen Querschnitt des Kontaktsteges reiben die Kontaktflächen zwischen dem Kontaktsteg und der Kontaktfeder über einen größeren Bereich aneinander. Außerdem wird durch diesen Querschnitt die Verflachung der Krümmung der gebogenen Kontaktfeder unterstützt, so daß sich diese mit ihrer Kontaktfläche auf der Kontaktfläche des die Kontaktfeder tragenden Teils reibend entlangbewegt. Durch diese Reibungsbewegung wird sowohl zwischen dem Kontaktsteg und der Kontaktfeder als auch zwischen der Kontaktfeder und dem sie tragenden Teil eine bessere Selbstreinigung erzielt. Darüber hinaus hat der keilförmige Querschnitt den Vorteil, daß dadurch der Anpreßdruck an die Kontaktfedern variiert und Fertigungstoleranzen ausgeglichen werden können. Durch den keilförmigen Querschnitt wird jedoch auch das Schließen der Tür, insbesondere im Bereich der Scharniere, erleichtert, wo die Bewegungsbahn des Kontaktsteges bzw. des Spaltes zwischen den Kontaktfedern durch die größere Nähe zum Drehpunkt stark gekrümmt ist. Durch die Schrägstellung der Oberflächen des Kontaktsteges können die Krümmungen wesentlich besser ausgeglichen werden.

Um die Kontaktfedern gegen Beschädigung zu schützen und um ein korrektes Schließen der Tür zu ermöglichen, sind die Kontaktfedern in der in Anspruch 7 beschriebenen Nut angeordnet.

Anspruch 8 beschreibt einen vorteilhaften Bereich der Öffnungswinkel des Keilquerschnittes, bei dem die Selbsthemmung des Kontaktsteges weitgehend vermieden wird.

Die Maßnahmen nach Anspruch 9 erlauben ein einfaches Einklipsen der Konntaktfedern, so daß diese leicht aus-und eingebaut werden können.

Ein Ausführungsbeispiel der Erfindung wird nachfolgend anhand der Zeichnungen näher erläutert. Es zeigen:

Fig. 1 eine Vorderansicht einer Kabine mit dem erfindungsgemäßen Dichtungssystem,

Fig. 2 einen vergrößerten Schnitt durch das erfindungsgemäße Dichtungssystem entlang II-II aus Fig. 1, und

Fig. 3 eine grafische Darstellung der erzielten Schirmdämpfungswerte.

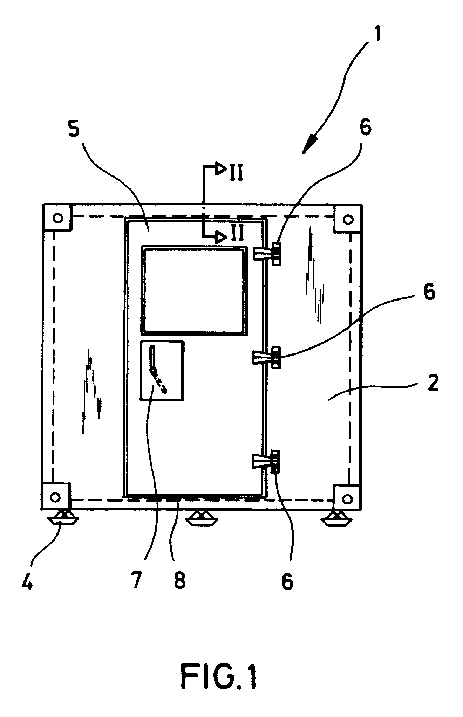

In Fig. 1 ist eine Vorderansicht einer üblichen mobilen, abgeschirmten Kabine 1 ersichtlich. Die Kabine 1 weist eine Vorderwand 2 in Sandwichbauweise mit Deckblechen aus Aluminium auf und steht auf Kufen 4. In der Vorderwand 2 ist eine Öffnung für eine Tür 5 ausgespart, die um Scharniere 6 verschwenkbar ist. Die Tür 5 enthält ein Schloß 7 (Schnapper, Sicherheitsschloß oder dgl.).

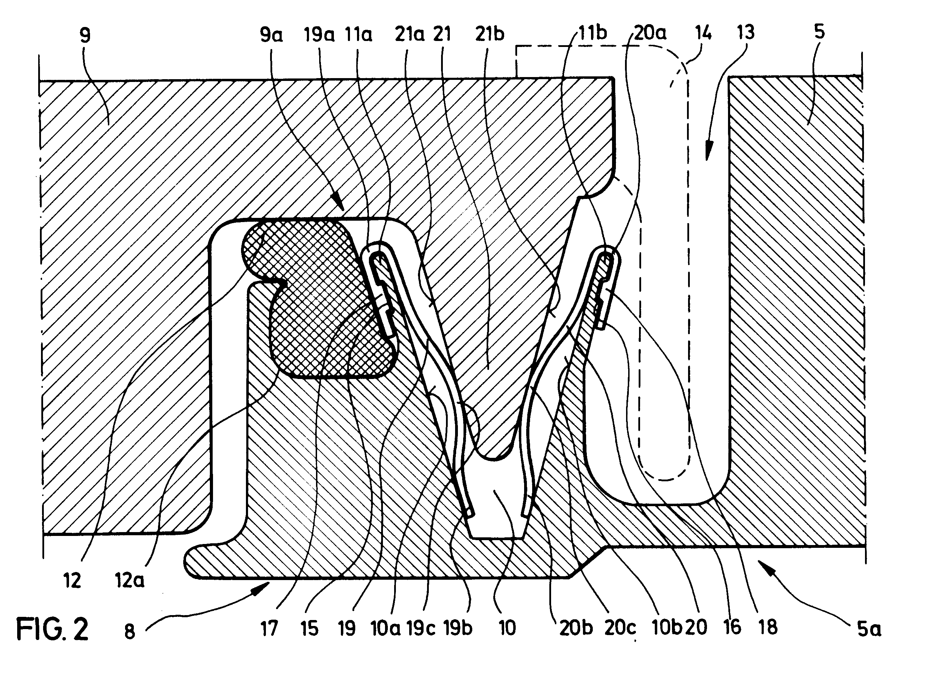

Zur Kontaktüberbrückung des Stoßbereiches zwischen der Wand 2 und der Tür 5 ist um den gesamten Umfang der Tür 5 ein Dichtungssystem 8 angeordnet, das in Fig. 2 näher dargestellt ist. Das Dichtungssystem 8 weist ein erstes, an der Tür 5 angeordnetes Dichtprofil 5a und ein zweites, an einem Türrahmen 9 angeordnetes Dichtprofil 9a auf, die einander überlappen. Das erste Dichtprofil 5a enthält eine umlaufende Nut 10 mit Keilquerschnitt, deren Flankenflächen 10a, 10b nach außen divergieren. Eine der Flankenflächen 10a ist zumindest teilweise an einem Begrenzungssteg 11a angeordnet, der mit seiner gegenüberliegenden Seite eine Ausnehmung 12a begrenzt, in die einer der üblichen elastischen Dichtungsstreifen 12 eingelegt ist. Die andere Flankenfläche 10b der Nut ist ebenfalls zumindest teilweise an einem Begrenzungssteg 11b angeordnet, der mit seiner anderen Seite eine Nut 13 für einen nicht näher dargestellten Trittschutz 14 begrenzt. An den der Nut 10 abgewandten Rückseiten der Begrenzungsstege 11a, 11b sind im Abstand vom oberen Rand Hinterschneidungen 15 bzw. 16 vorgesehen, die als einzelne Ausnehmungen bzw. als Nuten ausgebildet sein können. In die Hinterschneidungen 15 bzw. 16 greifen Vorsprünge 17 bzw. 18 von Kontaktfedern 19 bzw. 20 ein. Jede der Kontaktfedern 19 bzw. 20 ist streifenförmig ausgebildet und gegebenenfalls geschlitzt. Die Kontaktfedern 19 bzw. 20 sind derart gebogen, daß sie jeweils ein Befestigungsende 19a bzw. 20a aufweisen, das die Begrenzungsstege 11a, 11b federnd übergreift, wobei der Vorsprung 17 in die Ausnehmung 15 und der Vorsprung 18 in die Ausnehmung 16 einrasten. Die Kontaktfedern 19, 20 erstrecken sich mit freien Enden in die Nut 10 hinein und reichen nicht ganz bis zum Nutengrund. In der Nähe des Nutengrundes ist jeweils ein flacher Bereich 19b bzw. 20b vorgesehen, die eine Kontaktfläche zur jeweils anliegenden Flankenfläche 10a, 10b aufweisen. Zwischen dem flachen Bereich 19b, 20b und dem Befestigungsende 19a, 20a, ist jeweils ein gebogener Bereich 19c bzw. 20c vorgesehen, mit dem die Kontaktfedern 19 und 20 in das Innere der Nut 10 hineinragen.

Das Dichtprofil 9a am Türrahmen 9 weist einen Kontaktsteg 21 auf, der vom Türrahmen 9 in Richtung auf das Dichtprofil 5a vorsteht. Der Kontaktsteg 21 ist schmaler als die Nut 10 und weist einen keilförmigen Querschnitt mit zueinander konvergierenden Flankenflächen 21a, 21b auf, die miteinander den gleichen Winkel einschließen wie die Flankenflächen 10a, 10b der Nut 10. Vorteilhaft erweist sich ein Öffnungswinkel von 25° - 35°. Dadurch wird die Selbsthemmung des Kontaktsteges in den Kontaktfedern vermieden und die Tür kann ohne Kraftanwendung geöffnet werden. Der Kontaktsteg 21 ist so bemessen und angeordnet, daß er bei geschlossener Tür 5 zwischen die Kontaktfedern 19 bzw. 20 hineinragt, wobei sich zwischen den Flankenflächen 21a, 21b und den gebogenen Bereichen 19c, 20c Kontaktflächen ausbilden. Dabei werden die Kontaktfedern beiseitegedrückt. Im Idealfalle berührt der Kontaktsteg 21 die Kontaktfedern 19 bzw. 20 mit seinem vorderen bis mittleren Bereich und seine Mittellinie fällt mit der Mittellinie der Nut 10 zusammen. Durch die gewählte Form des Querschnitts des Kontaktsteges 21 sind jedoch sowohl Fertigungs- als auch Einbautoleranzen in Grenzen ausgleichbar.

Die Dichtprofile 5a und 9a bestehen aus Aluminium, dessen Oberfläche durch das übliche Flammspritzverfahren mit Zinn beschichtet wurde. Um die Haftung zwischen der Zinnbeschichtung und dem Aluminium zu verbessern, wurde Zink als Haftvermittler eingesetzt. Vor dem Beschichten werden die zu beschichtenden Flächen korundgestrahlt. Es sollte auf gute Haftung der Beschichtung an den Flankenflächen 21a, 21b des Kontaktsteges 21 und den Flankenflächen 10a, 10b der Nut 10, insbesondere in den jeweils mit den gebogenen Bereichen 19c, 20c bzw. flachen Bereichen 19b, 20b der Kontaktfedern 19, 20 in Berührung stehenden Kontaktflächen geachtet werden. Die Schichtdicke liegt beim Zink bei 100 $\mu$m und beim Zinn bei 100-200 $\mu$m. Die Kontaktfedern 19, 20 sind aus Berylliumkupfer und ebenfalls mit einer Zinnbeschichtung versehen. Die Schichtdicke liegt bei etwa 20 $\mu$m.

Wird die Tür 5 der Kabine 1 geschlossen, so bewegt sich das Dichtungsprofil 5a der Tür in Richtung auf das Dichtungsprofil 9a des Türrahmens, bis die Dichtung 12 anschlägt (und eventuell das Schloß 7 einschnappt). Während dieser Bewegung drückt sich der Kontaktsteg 21 zwischen die beiden Kontaktfedern 19 und 20 hinein, wobei der Abstand zwischen den Kontaktfedern 19 und 20 derart bemessen ist, daß diese in Richtung auf die Flankenflächen 10a bzw. 10b der Nut 10 auseinandergedrückt werden, wobei die Krümmung der gebogenen Bereiche 19c, 20c geringer wird. Dabei reiben die Flankenflächen 21a bzw. 21b auf der Oberfläche der gekrümmten Bereiche 19c bzw. 20c. Durch die Verflachung der Krümmung der gebogenen Bereiche 19c, 20c bewegt sich der ebene Bereich 19b bzw. 20b nach unten und reibt auf der anliegenden Flankenfläche 10a bzw. 10b der Nut. Wird die Tür 5 wieder geöffnet, so entstehen wiederum Relativbewegungen zwischen den Flankenflächen 21a, 21b und den anliegenden Oberflächen der gekrümmten Bereiche 19c, 20c einerseits und der einander zugewandten Oberflächen der ebenen Bereiche 19b, 20b und der Flankenflächen 10a, 10b der Nut 10 andererseits. Auf diese Weise können die Kontaktflächen saubergehalten und in gewissen Grenzen formschlüssig aneinander angepaßt werden.

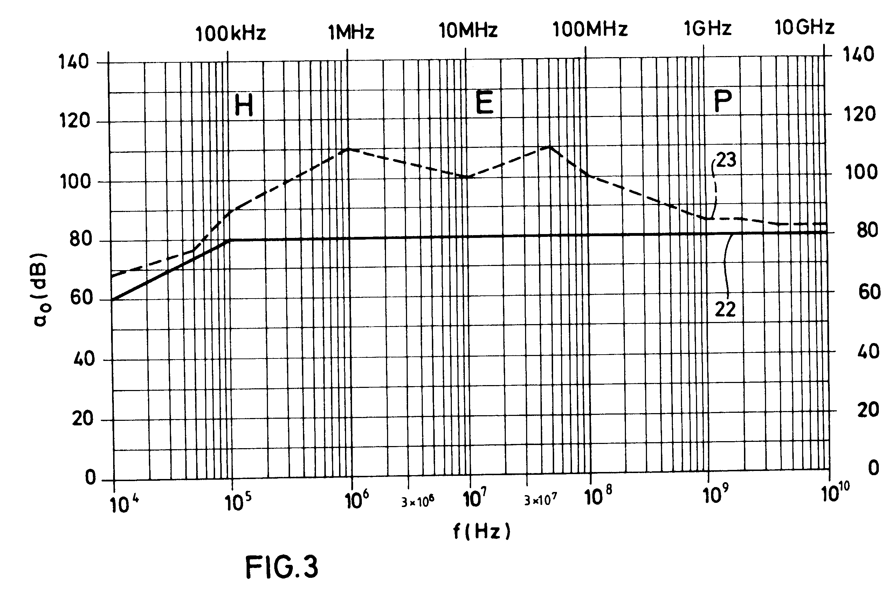

In Fig. 3 sind die festgestellten Schirmdämpfungswerte $a_o$ in dB im Frequenzbereich f von 10 kHz bis 10 GHz für hochfrequente Wellen mit ebener Wellenfront (P), magnetische (H) und elektrische (E) Felder an der erfindungsgemäßen Kabine, gemessen nach dem MIL STD-285, festgelegt z.B. in der NATO-Vorschrift 6516/SHCPE/87 "Allied command Europe, Standard Shelter Technical Specifications", grafisch dargestellt. Die gemessene Kabine enthielt einen verzinnten Kontaktsteg aus Aluminium und verzinnte Kontaktfedern aus Berylliumkupfer. In der grafischen Darstellung zeigt die durchgezogene Linie 22 die nach dem o.g.

Standard 6516/SHCPE/87 geforderten Werte und die gestrichelte Linie 23 den Schirmdämpfungsverlauf an der Eingangstür. Es ist ersichtlich, daß die Schirmdämpfungswerte auch an der Eingangstür weit oberhalb der geforderten Werte liegen (fast die Werte der ununterbrochenen Seitenwand erreichen). Diese Werte werden auch bei Langzeitbeanspruchung eingehalten, was die folgenden Langzeit- und Korrosionsversuche im Hinblick auf korrosive Belastungen bzw. mechanischen Abrieb ergaben:

**Langzeitversuche:**

An Original-Musterstücken des Abschirmungssystems wurden Versuche durchgeführt, um die Funktionstüchtigkeit über die volle Lebensdauer (ca 10 Jahre) ohne Reinigung und sonstige Wartungsarbeiten nachzuweisen.

**Korrosionstest:**

Die Musterstücke wurden im kontaktierten Zustand einem Salzsprühtest nach DIN 50021 unterzogen. Dauer 250 h. Gemessen wurde der Übergangswiderstand vor und nach der Prüfung.

**Ergebnisse:**

| | |
|---|---|
| Unbelastete Kontaktierung | $290\ \mu\Omega$ |
| Nach 250 h Salzsprühtest | $500\ \mu\Omega$ |

**Korrosionstest kombiniert mit Verschleißtest:**

| | |
|---|---|
| Nach 4000 Betätigungen unbelastet | $270\ \mu\Omega$ |
| Nach 4000 Betätigungen und 250 h Salzsprühtest | $530\ \mu\Omega$ |
| Nach 8000 Betätigungen unbelastet | $300\ \mu\Omega$ |
| Nach 8000 Betätigungen und 250 h Salzsprühtest | $2,3\ m\Omega$ |

Nach 8000 bis 10 000 Kontaktbetätigungen - dies entspricht bei einer Kabine ca 10 Jahren - wirkt sich der Verschleiß an der Zinnschicht der Kontaktfeder widerstandserhöhend aus. Nach ca 13 000 Lastwechsel sollte die Feder ausgewechselt werden, um die hohen Schirmdämpfungswerte einzuhalten. Die gemessenen niedrigen Übergangswiderstände im $\mu$- und Milli-$\Omega$-Bereich bestätigen die hervorragende Eignung des beschriebenen Verfahrens.

In Abwandlung des beschriebenen und gezeichneten Ausführungsbeispiels kann beispielsweise der Kontaktsteg auch an der Tür und die Nut am Türrahmen angeordnet sein. Es ist weiterhin nicht unbedingt notwendig, die Kontaktfedern zu verzinnen, wenn nur geringe Umweltbeanspruchung vorliegt und die Forderungen auf Wartungsfreiheit, Lebensdauer und Schirmdämpfung abgemindert sind. Eine Verzinnung kann auch dann zweckmäßig sein, wenn einer oder beide Dichtprofile aus anderen Werkstoffen als Aluminium bestehen. Als Haftvermittler eignen sich außer Zink auch andere Metalle mit einem höheren Schmelzpunkt als Zink. Die Beschichtung kann darüber hinaus auch mit einem Lichtbogenverfahren aufgebracht werden.

**Patentansprüche**

1. Elektromagnetisch abgeschirmte Kabine (1) mit einem Dichtungssystem (8) für einen Stoßbereich zwischen einem feststehenden Bauteil (2) und einem beweglichen Wandteil, wie Tür (5), Klappe, Luke oder Fenster, wobei mit dem einen Teil (2, 5) zwei im Abstand zueinander angeordnete, gebogene Kontaktfedern (19, 20) verbunden sind, zwischen die ein mit dem anderen Teil (5, 2) verbundener Kontaktsteg (21) eindrückbar ist, wobei zwischen dem Kontaktsteg (21) und den Kontaktfedern (19, 20) sowie den Kontaktfedern (19, 20) und dem einen Teil (2, 5) jeweils Kontaktflächen ausgebildet sind, **dadurch gekennzeichnet,** daß die Kontaktflächen die insbesondere aus Aluminium bestehen, mit einer Beschichtung aus Zinn versehen sind.

2. Kabine nach Anspruch 1, **dadurch gekennzeichnet,** daß als Haftvermittler zwischen einer Aluminiumoberfläche und dem Zinn ein Metall mit höherer Schmelztemperatur als Zinn vorgesehen ist.

3. Kabine nach Anspruch 2, **dadurch gekennzeichnet,** daß als Haftvermittler Zink vorgesehen ist.

4. Kabine nach einem der Ansprüche 1 bis 3, **dadurch gekennzeichnet,** daß auch die Kontaktfedern (19, 20) eine Beschichtung aus Zinn aufweisen.

5. Kabine nach einem der Ansprüche 1 bis 4, **dadurch gekennzeichnet,** daß die Beschichtung durch Flammspritzen aufgebracht ist.

6. Kabine nach einem der Ansprüche 1 bis 5, **dadurch gekennzeichnet,** daß der Kontaktsteg (21) einen sich in Richtung auf die Kontaktfedern (19, 20) verjüngenden, keilförmigen Querschnitt aufweist.

7. Kabine nach einem der Ansprüche 1 bis 6, **dadurch gekennzeichnet,** daß die Kontaktfedern (19, 20) in einer Nut (10) angeordnet sind, die einen zum Kontaktsteg (21) korrespondierenden keilförmigen Querschnitt aufweist.

8. Kabine nach Anspruch 6 oder 7, **dadurch gekennzeichnet,** daß der keilförmige Querschnitt einen Öffnungswinkel von 25° bis 35° aufweist.

9. Kabine nach Anspruch 7 oder 8, **dadurch gekennzeichnet,** daß gegenüberliegende Begrenzungswände (11a, 11b) der Nut (10) Hinterschneidungen (15, 16) aufweisen, in die an den Kontaktfedern (19, 20) angeordnete Vorsprünge (17, 18) einrastbar sind.

**Claims**

1. An electromagnetically shielded chamber (1) comprising a sealing system (8) for an area of abutment between a fixed structural part (2) and a mobile wall part such as a door (5), flap, hatch or window, there being connected to the one part (2, 5) two curved contact springs (19, 20), arranged so as to be spaced apart from one another, between which a contact bar (21) connected to the other part (5, 2) may be pressed in, respective contact surfaces being formed between the contact bar (21) and the contact springs (19, 20) and between the contact springs (19, 20) and the one part (2, 5), characterised in that the contact surfaces, which, more particularly, are made of aluminium, are provided with a coating of tin.

2. A chamber according to claim 1, characterised in that a metal with a higher melting temperature than tin is provided as the adhesive agent between an aluminium surface and the tin.

3. A chamber according to claim 2, characterised in that zinc is provided as the adhesive agent.

4. A chamber according to one of claims 1 to 3, characterised in that the contact springs (19, 20) also have a coating of tin.

5. A chamber according to one of claims 1 to 4, characterised in that the coating is applied by means of flame-spraying.

6. A chamber according to one of claims 1 to 5, characterised in that the cross-section of the contact bar (21) is wedge-shaped and tapers in the direction of the contact springs (19, 20).

7. A chamber according to one of claims 1 to 6, characterised in that the contact springs (19, 20) are arranged in a groove (10), the cross-section of which is wedge-shaped and corresponds with the contact bar (21).

8. A chamber according to claim 6 or 7, characterised in that the wedge-shaped cross-section has an angle of aperture of 25° to 35°.

9. A chamber according to claim 7 or 8, characterised in that opposite boundary walls (11a, 11b) of the groove (10) have undercuts (15, 16) into which projections (17, 18) arranged on the contact springs (19, 20) may be engaged.

**Revendications**

1. Cabine (1) blindée contre les ondes électromagnétiques comportant un système d'étanchéité (8) pour une zone de choc entre une partie constitutive fixe (2) et une partie de paroi mobile, telle que porte (5), abattant, hublot ou fenêtre, deux ressorts de contact (19, 20) cintrés, espacés l'un de l'autre, entre lesquels peut être enfoncée une languette de contact (21) reliée avec une partie (5, 2), étant reliés avec une l'autre partie (2, 5), des surfaces de contact étant formées entre la languette de contact (21) et les ressorts de contact (19, 20), ainsi qu'entre les ressorts de contact (19, 20) et une partie (2, 5), caractérisée en ce que les surfaces de contact, qui sont en particulier en aluminium, sont recouvertes d'une couche d'étain.

2. Cabine selon la revendication 1, caractérisée en ce qu'il est prévu un métal dont la température de fusion est supérieure à celle de l'étain, comme agent adhésif entre une surface en aluminium et l'étain.

3. Cabine selon la revendication 2, caractérisée en ce qu'il est prévu du zinc comme agent adhésif.

4. Cabine selon l'une des revendications 1 à 3, caractérisée en ce que les ressort de contact (19, 20) sont aussi recouverts d'une couche d'étain.

5. Cabine selon l'une des revendications 1 à 4, caractérisée en ce que la couche de revêtement est appliquée par projection à la flamme.

6. Cabine selon l'une des revendications 1 à 5, caractérisée en ce que la languette de contact (21) présente une section transversale conique, se rétrécissant en direction des ressorts de contact (19, 20).

7. Cabine selon l'une des revendications 1 à 6, caractérisée en ce que les ressorts de contact (19, 20) sont placés dans une rainure (10) qui présente une section transversale conique, correspondant à la languette de contact (21).

8. Cabine selon la revendication 6 ou 7, caractérisée en ce que la section transversale conique présente un angle d'ouverture compris entre 25° et 35°.

9. Cabine selon la revendication 7 ou 8, caractérisée en ce que des parois de délimitation (11a, 11b), opposées l'une à l'autre, de la rainure (10), présentent des détalonnages (15, 16) dans lesquels peuvent s'accrocher des parties saillantes (17, 18) pratiquées sur les ressorts de contact (19, 20).

FIG.1

FIG. 2

EP 0 320 592 B1

FIG.3